# EUROPÄISCHE PATENTSCHRIFT

(11) **EP 2 580 784 B1**
(45) Veröffentlichungstag und Bekanntmachung des Hinweises auf die Patenterteilung: **13.04.2016**
(21) Anmeldenummer: 11714319.8
(22) Anmeldetag: 15.04.2011
(51) Int. Cl.: H01L 31/0224, H01L 31/18, H05K 3/12

(54) **VERFAHREN UND VORRICHTUNG ZUM KONTAKTIEREN EINES HALBLEITERSUBSTRATES MITTELS EINES STRAHLDRUCKVERFAHRENS**
METHOD AND DEVICE FOR CONTACTING A SEMICONDUCTOR SUBSTRATE BY MEANS OF A JET PRINTING METHOD
PROCÉDÉ ET DISPOSITIF POUR METTRE EN CONTACT UN SUBSTRAT SEMI-CONDUCTEUR PAR UN PROCÉDÉ D'IMPRESSION PAR JET D'ENCRE

(30) Priorität: 10.06.2010 DE 102010029939
(43) Veröffentlichungstag der Anmeldung: 17.04.2013
(73) Patentinhaber: SolarWorld Industries Thüringen GmbH, 99310 Arnstadt (DE)
(72) Erfinder: FUNK, Karsten, 99425 Weimar (DE)
(74) Vertreter: Isarpatent
(86) Internationale Anmeldenummer: PCT/EP2011/055974
(87) Internationale Veröffentlichungsnummer: WO 2011/154184

(56) Entgegenhaltungen:
- EP-A1- 1 942 710
- EP-A2- 1 452 326
- WO-A1-2009/139060
- KR-A- 20090 106 853

## Beschreibung

Die Erfindung betrifft ein Verfahren zum Kontaktieren eines Halbleitersubstrates mittels eines Strahldruckverfahrens nach Anspruch 1 und eine Vorrichtung zum Kontaktieren eines Halbleitersubstrates mittels eines Strahldruckverfahrens nach Anspruch 8.

### Stand der Technik

Für fragile, d. h. zerbrechliche und dünne Halbleitersubstrate, die vor allem im Bereich der Solartechnik angewendet werden, sind kontaktgebundene Beschichtungsverfahren, beispielsweise ein Siebdruck, aus mechanischen Gründen nicht mehr einsetzbar. Die beim Siebdruck notwendige mechanische Kraft, um das pastöse Siebdruckmaterial durch eine Siebmaske auf das zu bedruckende Substrat aufzubringen, muss durch das Substrat aufgenommen werden. Bei zunehmend dünneren Halbleitersubstraten und Wafern ergibt sich eine Einsatzgrenze des Siebdruckverfahrens durch die abnehmende Bruchfestigkeit der zu bedruckenden Substrate.

Alternativ zum Siebdruckverfahren kann auch ein nicht kontaktgebundenes Tintenstrahldruckverfahren verwendet werden. Dabei wird eine Tinte, die elektrisch leitfähige Partikel enthält, in Form kleiner Tröpfchen, den sogenannten Droplets, aus einer Tintenstrahldüse auf das Substrat gespritzt. Damit die Tinte spritzfähig ist, muss deren Viskosität hinreichend niedrig sein. Dies bringt wiederum den Nachteil mit sich, dass die auf dem nicht saugfähigen und glatten Halbleitersubstrat auftreffenden Droplets breitlaufen, sodass die aufgedruckte Struktur vergleichsweise breit wird. Für die Kontaktierung von Halbleitersubstraten bei solaren Anwendungen sind jedoch vorwiegend schmale und hohe Strukturen erwünscht. Bei derartigen Strukturen ist die Abschattung der darunter befindlichen Teile des Halbleitersubstrates minimiert, während die elektrische Leitfähigkeit der aufgebrachten Strukturen optimale Werte annimmt. Derartige Strukturen können jedoch nur durch dickflüssige und pastöse Materialien erreicht werden. Diese eignen sich jedoch für das Tintenstrahldruckverfahren nicht und können nur mit dem die Halbleitersubstrate mechanisch belastenden Siebdruckverfahren verarbeitet werden.

Die Druckschrift WO 2009/139060 A1 offenbart ein Verfahren zum Herstellen einer Licht-Matrixanordnung und eine Vorrichtung hierfür. WO 2009/139060 A1 offenbart insbesondere in Fig. 5 eine Anordnung aus einer Tintenstrahldüse, einem Lasergenerator und einem Substrat. Sowohl die Tintenstrahldüse als auch der Lasergenerator sind auf das Substrat gerichtet. Die Beeinflussung der aus der Tintenstrahldüse abgegebenen Droplets findet daher am Auftreffpunkt, also auf der Oberfläche des Substrates, statt.

Die Druckschrift KR10-2009-0106853 offenbart in Fig. 2 eine Düsenanordnung 140 und ein Mittel 180 zur Beeinflussung des Düsenoutputs. Sowohl die Düsenanordnung als auch das Mittel sind auf die Oberfläche eines Substrates S gerichtet. Der Düsenoutput wird also in jedem Fall dort beeinflusst, wo er schließlich deponiert werden soll und zwar auf dem Substrat, d. h. nach dem Durchlaufen der Flugbahn.

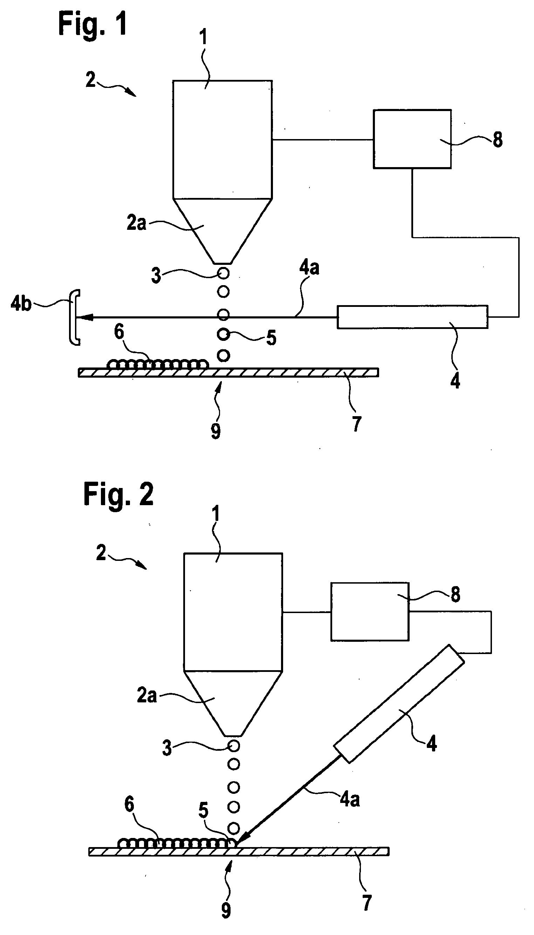

Die Druckschrift EP 1 452 326 A2 offenbart ein Verfahren und eine Vorrichtung zum Fixieren eines Funktionsmaterials auf einer Oberfläche. Das dort offenbarte Verfahren läuft zweistufig ab. In einem "ejection step" wird das Material tropfenförmig auf einem Substrat abgesetzt. In einem nachfolgenden "drying step" wird das nun auf dem Substrat befindliche Material getrocknet. Das abgesetzte Material bleibt also in seiner Flugbahn unverändert (vgl. sämtliche Ausführungsformen in den Figuren 1 bis 4). Darüber hinaus lehrt EP 1 452 326 A2 ein indirektes Beeinflussen durch ein Aufheizen des Substrates von unten (vgl. Ausführungsbeispiel aus Fig. 11).

### Offenbarung der Erfindung

Es stellt sich somit die der Erfindung zugrunde liegende Aufgabe, ein Verfahren zur Kontaktierung eines Halbleitersubstrates anzugeben, bei dem die mechanische Belastung des Halbleitersubstrates minimiert ist oder nach Möglichkeit im wesentlichen ganz entfällt, während die aufgebrachten elektrisch leitenden Strukturen möglichst schmal und hoch ausgebildet sind und damit eine minimale Abschattung bei einer optimalen elektrischen Leitfähigkeit aufweisen.

Es stellt sich weiterhin die Aufgabe, eine Vorrichtung zur Kontaktierung eines Halbleitersubstrates anzugeben, mit der die erwähnten Eigenschaften der Kontaktierungsstrukturen erreicht werden und mit dem eine Kontaktierung mit einer minimalen mechanischen Belastung des Halbleitersubstrates vorgenommen werden kann.

Die Aufgabe wird mit einem Verfahren zum Kontaktieren eines Halbleitersubstrates mit den Merkmalen des Anspruchs 1 und mit einer Vorrichtung zum Kontaktieren eines Halbleitersubstrates mit den Merkmalen der Ansprüche 6 und 7 gelöst.

Erfindungsgemäß erfolgt das Verfahren zum Kontaktierung eines Halbleitersubstrates mittels eines Strahldruckverfahrens, wobei folgende Verfahrensschritte ausgeführt werden:

Es wird ein Kontaktiermittel in einem niedrigviskosen Ausgangszustand bereitgestellt. Das niedrigviskose Kontaktiermittel wird durch eine Düsenanordnung hindurchgetrieben. Unmittelbar darauf wird das Kontaktiermittel mit einem Energieeintrag und/oder einem chemischen Reaktionsmittel zum Überführen des Kontaktiermittels in einen höherviskosen Endzustand beaufschlagt. Dieses Beaufschlagen erfolgt unmittelbar nach dem Düsendurchtritt.

Das Beaufschlagen des Kontaktiermittels erfolgt durch einen in die Flugbahn gerichteten Laserstrahl. Laserlicht lässt sich sehr gut fokussieren und weist eine hinreichend große Leistungsdichte auf, um die erforderliche Viskositätszunahme des in Form der Droplets vorliegenden Kontaktiermittels in einer kurzen Zeit zu bewirken.

Es ist jedoch auch möglich, dass das Beaufschlagen des Kontaktiermittels durch ein gerichtetes Wärmefeld, eine gerichtete Mikrowellenstrahlung, eine Plasmaeinwirkung und/oder einen chemisch aktiven Gasstrahl erfolgt. Auch in diesem Fall wird die Einwirkung auf das Kontaktiermittel konzentriert.

Grundgedanke des Verfahrens ist es somit, das Strahldruckverfahren so zu gestalten, dass das Kontaktiermittel unmittelbar nachdem es die Düsenanordnung verlassen hat so zu verfestigen, dass dessen Viskosität beträchtlich ansteigt, sodass das Kontaktiermittel in einem quasi pastösen Zustand auf dem Halbleitersubstrat abgesetzt wird. Das Kontaktiermittel hat praktisch keine Zeit dazu, auf dem Halbleitersubstrat breit zu laufen, sondern wird während des Druckvorgangs eingedickt. Dabei kann aber das mechanisch schonende Strahldruckverfahren in vollem Umfang angewendet werden, wodurch die mechanische Beanspruchung des Halbleitersubstrates beträchtlich minimiert ist.

Zweckmäßigerweise erfolgt bei einer ersten Ausführungsform das Beaufschlagen des Kontaktiermittels durch eine strahlförmig gerichtete Energieeinwirkung. Dadurch erfolgt eine Fokussierung der Energieeinwirkung auf entweder in der Flugbahn befindliche oder gerade auf dem Halbleitersubstrat aufgekommene Droplets des Kontaktiermittels, wobei deren Viskosität hinreichend schnell zunimmt.

Bei einer zweckmäßigen Ausführungsform erfolgt das Beaufschlagen des Kontaktiermittels zeitlich pulsförmig. Dabei ist eine Zeittaktung der pulsförmigen Beaufschlagung mit einer Zeittaktung eines Pulsbetriebs der insbesondere Tintenstrahl-Düsenanordnung synchronisiert. Die Beaufschlagung findet nur dann statt, d. h. der Laserstrahl feuert nur dann oder die entsprechenden anderen Beaufschlagungsmittel sind nur dann aktiv, wenn ein Droplet die Tintenstrahl-Düsenanordnung verlässt oder gerade nach einer gewissen Flugzeit auf dem Halbleitersubstrat angelangt ist. Dadurch kann eine Wärmebelastung des Halbleitersubstrates minimiert oder auch ein unnötiger Energieverbrauch vermieden werden, während sich während des Pulsens eine hohe Leistungsdichte erreichen lässt.

Bei einer zweckmäßigen Ausgestaltung erfolgt das Beaufschlagen des Kontaktiermittels durch eine aufgefächerte Strahleinwirkung mit einem Überstreichen eines Druckbereichs mindestens einer Tintenstrahldüse. Eine derartige Ausgestaltung ist dann sinnvoll, wenn die Tintenstrahl-Düsenanordnung aus mehreren Einzeldüsen besteht. Dann wird die strahlförmige Energiebeaufschlagung jeweils in den Bereich der Einzeldüsen gelenkt und definiert aufgefächert.

Vorteilhaft ist es, wenn das Beaufschlagen selektiv auf eine Einwirkung auf einzelne stoffliche Anteile des Kontaktiermittels abgestimmt ist. Dabei wird über eine dadurch bewirkte Änderung des Mischungsverhältnisses des Kontaktiermittels eine gezielte Viskositätsänderung bewirkt. Es lässt sich dadurch die letztlich auf dem Halbleitersubstrat entstehende Struktur über den Energieeintrag in gewissen Grenzen beeinflussen.

Vorrichtungsseitig ist zum Kontaktieren eines Halbleitersubstrates mittels eines Tintenstrahldruckverfahrens eine Vorrichtung vorgesehen, die ein Vorratsbehältnis für ein niedrigviskoses Kontaktiermittel, eine nachgeschaltete Tintenstrahl-Düsenan-ordnung und eine auf einen Strahlbereich der Tintenstrahl-Düsenanordnung und/oder auf einen Auftreffpunkt des Kontaktiermittels gerichtete energetische und/oder chemische Beaufschlagungseinheit enthält.

Die Beaufschlagungseinheit weist bei einer zweckmäßigen Ausgestaltung eine Auffächerungsanordnung für ein mindestens zweidimensionales Verteilen der Energiebeaufschlagung über einen Druckbereich mindestens einer Tintenstrahldüse auf.

Zweckmäßigerweise ist die Beaufschlagungseinheit als eine Laservorrichtung ausgebildet. Alternativ oder in Kombination dazu ist die Energiebeaufschlagungseinheit als eine gerichtete thermische Strahleinheit, eine IR-Strahleinheit, eine UV/VIS-Strahleinheit, eine Mikrowellenstrahleinheit, eine Plasmaeinheit und/oder eine Gasstrahleinheit für ein chemisch aktives Gas ausgebildet.

### Zeichnungen

Das erfindungsgemäße Verfahren und die erfindungsgemäße Vorrichtung sollen nachfolgend anhand von Ausführungsbeispielen näher erläutert werden. Zur Verdeutlichung dienen die beigefügten Figuren 1 bis 7. Es werden für gleiche oder gleichwirkende Teile die selben Bezugszeichen verwendet.

Es zeigen:
- Fig. 1: eine beispielhafte Tintenstrahl-Druckanordnung mit einer Lasereinheit,
- Fig. 2: eine beispielhafte Tintenstrahl-Druckanordnung mit einer auf den Auftreffpunkt auf dem Halbleitersubstrat gerichteten Lasereinheit,
- Fig. 3: eine beispielhafte Tintenstrahl-Druckanordnung mit einer Mikrowelleneinheit,
- Fig. 4: eine beispielhafte Tintenstrahl-Druckanordnung mit einer Gasstrahleinheit,
- Fig. 5: eine beispielhafte Tintenstrahl-Druckanordnung mit einer Mikrowelleneinheit und einer Gasstrahleinheit,
- Fig. 6: eine beispielhafte Tintenstrahl-Druckanordnung mit einer Mikrowelleneinheit und einer Plasmazuführung,
- Fig. 7: eine beispielhafte Auffächerungseinheit für einen Laserstrahl.

Fig. 1 zeigt eine beispielhafte Tintenstrahl-Druckanordnung für eine Energiebeaufschlagung mittels Laserlicht. Ein Vorratsbehälter mit einem Kontaktiermittel **1** in einem niedrigviskosen Ausgangszustand bilden einen Teil einer Tintenstrahl-Düsenanordnung **2.** Diese enthält weiterhin eine Tintenstrahldüse **2a.** Die Tintenstrahl-Düsen-anordnung besteht beispielsweise aus einer Kartusche, bei der der Vorratsbehälter und die Tintenstrahldüse in einer einzigen Baugruppe integriert sind.

Bei dem Druckvorgang wird das niedrigviskose Kontaktiermittel durch die Tintenstrahldüse getrieben. Hierzu kann auf die üblichen Antriebsverfahren, insbesondere auf ein piezoelektrisches oder ein thermisches Verfahren zum Druckaufbau, zurückgegriffen werden. Bei diesem Vorgang zerlegt sich das niedrigviskose Kontaktiermittel in kleine Tröpfchen, so genannte Droplets **3**, und wird pulsartig aus der Düse geschleudert. Die Droplets passieren auf ihrem Weg zu einem gegenüber der Düse liegenden Halbleitersubstrat **7** den Strahlengang einer Laservorrichtung **4**. Diese sendet einen Laserstrahl **4a** aus, der die Droplets innerhalb ihrer Bahn mit Energie beaufschlagt. Der Laserstrahl wird schließlich von einer Barriere **4b** absorbiert.

Durch die Energiebeaufschlagung wird das niedrigviskose Droplet **3** während des Fluges von der Tintenstrahldüse zum Halbleitersubstrat in ein höherviskoses, insbesondere pastöses Droplet **5** überführt. Das höherviskose Droplet wird entlang einer Kontaktierungsspur **6** auf dem Halbleitersubstrat **7** abgesetzt. Durch die nun zähflüssige Beschaffenheit des Droplets **5** läuft das Kontaktiermittel nicht breit. Die Kontaktierungsspur ist dadurch schmal und weist eine Höhe auf, die im Wesentlichen dem Durchmesser eines Droplets **5** entspricht.

Bei der hier gezeigten Ausführungsform ist die Tintenstrahl-Düsenanordnung **2** mit der Laservorrichtung **4** über eine Synchronisiereinheit **8** verknüpft. Unter dem Einfluss der Synchronisiereinheit sendet die Laservorrichtung **4** Laserlicht in Form einzelner Pulse aus. Dabei wird der Zeitpunkt eines einzelnen Laserpulses mit dem Zeitpunkt des Ausstoßens eines Droplets **3** aus der Tintenstrahldüse synchronisiert. Durch eine geeignete Abstimmung des Pulstaktes an der Laservorrichtung und des Ausstoßtaktes der Droplets kann die Form der gedruckten Kontaktierungsspur innerhalb gewisser Grenzen beeinflusst werden. So ist es beispielsweise möglich, nur jedes zweite Droplet einem Laserpuls auszusetzen, sodass die Kontaktierungsspur an verschiedenen Stellen verschieden breit ausfällt und somit ein charakteristisches Dicken- und Höhenprofil erhält.

Fig. 2 zeigt eine Vorrichtung gemäß Fig. 1, bei der die Laservorrichtung auf einen Auftreffbereich **9** der Droplets **3** auf dem Halbleitersubstrat **7** gerichtet ist. Bei dieser Ausführungsform behalten die Droplets **3** ihren niedrigviskosen Zustand während der gesamten Flugphase und werden erst unmittelbar auf dem Substrat in die höherviskosen Droplets **5** umgeformt. Diese Ausführungsform stellt geringere Anforderungen an die Justage der Laservorrichtung **4**, allerdings erhöht sich auch die thermische und photochemische Belastung des Halbleitersubstrates infolge des unmittelbar auf der Oberfläche liegenden Laserfokus. Die Belastung des Halbleitersubstrates lässt sich allerdings dadurch begrenzen, indem der Zeitpunkt des Laserpulses geeignet mit dem Zeitpunkt des Dropletausstoßes an der Tintenstrahldüse **2a** synchronisiert wird. Dabei gelingt es, zunächst das noch niedrigviskose Droplet auf dem Halbleitersubstrat abzusetzen, es aber unmittelbar darauf mit dem Laserpuls zu beaufschlagen und somit in das höherviskose Droplet zu überführen, noch bevor das Breitfließen des Droplets einsetzt. Der Laserpuls trifft somit nicht das ungeschützte Halbleitersubstrat, sondern die mit dem Droplet bereits bedeckte Fläche. Das Halbleitersubstrat wird dadurch abgeschirmt und vor der direkten Einwirkung des Lasers geschützt.

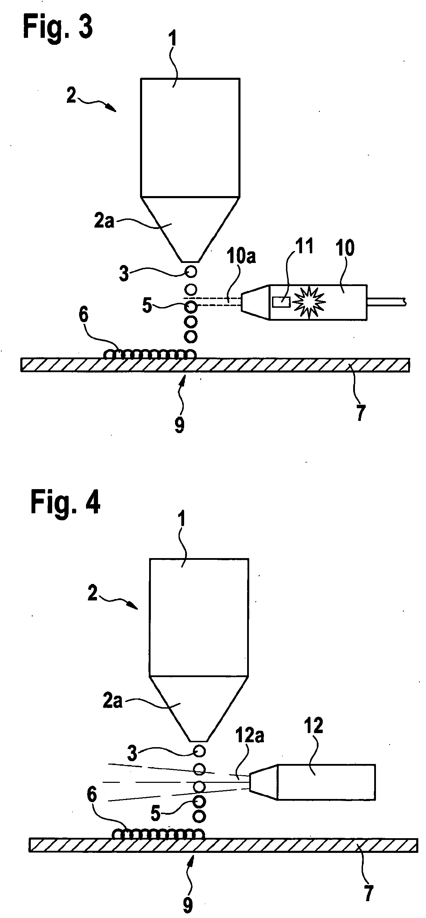

Anstelle einer Beaufschlagung mit Laserlicht sind auch andere Einwirkungen zum Überführen der niedrigviskosen Droplets **3** in die höherviskosen Droplets **5** möglich. Bei dem Ausführungsbeispiel aus Fig. 3 ist hierfür eine Mikrowellenstrahleinheit **10** vorgesehen. Diese enthält eine Mikrowellenquelle, beispielsweise ein gegen die Umgebung abgeschirmtes Impuls- oder Dauerstrich-Magnetron und eine Shutterblende **11,** die zusammen einen pulsartigen und hinreichend kollimierten Mikrowellenstrahl **10a** erzeugen. Bei dem hier gezeigten Ausführungsbeispiel durchlaufen die ausgestoßenen Droplets **3** den Mikrowellenstrahl **10a** und werden dadurch in die höherviskosen Droplets **5** umgeformt, die wie beschrieben die erhabene und schmale Kontaktierungsspur **6** auf dem Halbleitersubstrat **7** ausbilden. Natürlich kann auch in dem hier vorliegenden Beispiel eine Synchronisierung zwischen dem Pulsbetrieb der Tintenstrahl-Düsenanordnung **2**, insbesondere der Tintenstrahldüse **2a** und dem Pulsbetrieb der Mikrowellenstrahleinheit, d. h. dem Betrieb des Magnetrons und der Shutterblende **11**, erfolgen.

Anstelle der Mikrowellenstrahleinheit ist auch die Verwendung einer IR- oder UV/VIS-Strahleinheit möglich. Dabei werden die Droplets mit Wärmestrahlung oder Ultraviolettstrahlung bzw. sichtbarem Licht beaufschlagt. Ausführbar ist auch eine Anordnung mit einer Röntgenquelle oder eine Verwendung einer radioaktiven Gammastrahlungsquelle, die ebenfalls mit einer Shutteranordnung kombinierbar sind.

Die Droplets können jedoch auch einer chemischen Einwirkung unterzogen werden. Fig. 4 zeigt hierfür ein weiteres Beispiel. Bei der hier gezeigten Vorrichtung ist eine Düseneinrichtung **12** vorgesehen, die einen chemisch aktiven Gasstrahl **12a** in die Flugbahn der Droplets **3** ausstößt. Dabei werden chemische Reaktionen innerhalb der Droplets bewirkt, die zu deren Umwandlung in die höherviskosen Droplets **5** führen. Als chemisch aktives Gas kann beispielsweise Ozon, Chlor oder Schwefelwasserstoff verwendet werden. Ebenso ist auch die Anwendung eines festen oder flüssigen chemisch reaktionsfähigen Aerosols aus fein verteilten Partikeln oder Tröpfchen in einem inerten Trägergas möglich.

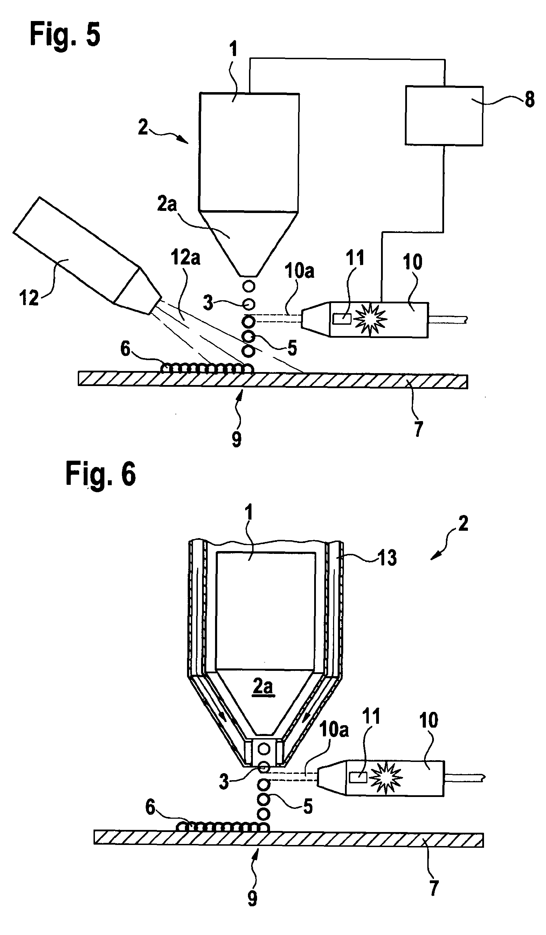

Anstelle des chemisch aktiven Gasstroms kann auch ein stark abgekühltes Inertgas, insbesondere entspanntes Kohlendioxid in Form eines Strahls aus Trockeneis-Schnee, verwendet werden. Dabei werden die Droplets "eingefroren" und somit in ihrer Viskosität stark erhöht. Die auf dem Substrat deponierten hochviskosen und vorübergehend erstarrten Droplets können anschließend durch die Einwirkung von Laserlicht oder anderer elektromagnetischer Strahlung endgültig auf dem Substrat fixiert werden.
Es können auch verschiedene Beaufschlagungsarten und -mittel kombiniert sein. Fig. 5 zeigt eine beispielhafte Kombination aus der Mikrowellenstrahlanordnung nach Fig. 3 und einer Ausführungsform der in Fig. 4 dargestellten Gasstromanordnung. Bei dieser Ausführungsform ist die Richtung des Mikrowellenstrahls **10a** aus der Mikrowellenstrahleinheit **10** quer zur Flugrichtung der Droplets **3** orientiert, während die Düseneinrichtung **12** auf den Auftreffpunkt **9** der Droplets auf dem Halbleitersubstrat **7** gerichtet ist. Der von der Düseneinrichtung **12** ausgesandte Gasstrom **12a** bildet dabei eine lokale Gasatmosphäre im Gebiet des Auftreffbereiches **9** aus, in welcher die durch die einwirkenden Mikrowellen vorbehandelten Droplets **3** endgültig verfestigen können und eine pastöse bis feste Beschaffenheit annehmen.

Fig. 6 zeigt eine Kombination aus einer Plasmazuführung **13** mit einer Mikrowellenstrahlanordnung **10**. Die Plasmazuführung umschließt hier die Tintenstrahl-Düsenanordnung **2** zumindest abschnittsweise so, dass das herangeführte Plasma in Richtung der ausgestoßenen Droplets **3** abgegeben wird und unmittelbar vor der Mündung der Tintenstrahldüse **2a** auf die Droplets auftrifft. Dadurch kann bereits kurz nach der Mündung der Tintenstrahldüse ein Umformen der Droplets eingeleitet werden, die gegebenenfalls auch ohne weitere Mittel zum Energieeintrag zu den gewünschten höherviskosen Droplets **5** führt.

Anstelle der Plasmazuführung kann natürlich auch eine entsprechend ausgebildete Gaszuführung vorgesehen sein, die kein Plasma in den Druckbereich einträgt, aber die ausgestoßenen Droplets allseitig in einer reaktiven Atmosphäre umgibt. Die in der Figur zusätzlich vorhandene Mikrowellenstrahlanordnung **10** bewirkt eine abschließende Viskositätsänderung der Droplets.

Natürlich kann bei den genannten Ausführungsbeispielen anstelle der Mikrowellenstrahlanordnung in jedem Fall auch die Laservorrichtung **4** aus einem der beiden Beispiele aus Fig. 1 oder 2 oder eine andere elektromagnetische Strahlenquelle verwendet werden. Die zweckmäßige Wahl hängt im Wesentlichen von der Zusammensetzung des Kontaktiermittels und den dabei zu bewirkenden Umwandlungsprozessen innerhalb der Droplets ab. So empfiehlt sich beispielsweise eine Laservorrichtung kann, wenn ein Lösungsmittel innerhalb des Droplets photochemisch zu aktivieren ist, welches nachfolgend innerhalb der lokalen Gasatmosphäre vernetzen und damit eine dickflüssige Beschaffenheit annehmen soll.

Die Verwendung einer Mikrowellenstrahlanordnung oder einer IR-Quelle in Verbindung mit einer Gasquelle ist dann angezeigt, wenn Droplets eines Kontaktiermittels mit Wasseranteil zu verfestigen sind. In diesem Fall ist die lokale Gasatmosphäre dafür vorgesehen, den entstehenden Wasserdampf zu verdrängen, auszublasen oder chemisch zu binden und ihn somit aus dem Druckbereich zu entfernen.

Es ist zweckmäßig, wenn die Art des Energieeintrages auf bestimmte Komponenten des Kontaktiermittels, insbesondere bestimmte Lösungsmittel abgestimmt ist. So kann beispielsweise eine erste Lösungsmittelkomponente durch die Einwirkung des Lasers aus dem Droplet entfernt werden, wobei das Droplet einen ersten höherviskosen Zustand annimmt, während eine zusätzlich eingetragene Wärmestrahlung eine weitere Viskositätszunahme des Droplets bewirkt. Über ein Zu- oder Abschalten des Lasers, bzw. eine Intensitätsänderung der Wärmestrahlung lässt sich somit die Viskosität des Droplets gezielt ändern und die Gestalt der entstehenden Kontaktierungsspur sehr genau beeinflussen.

In einem dem beschriebenen Druckverfahren nachfolgenden Schritt wird die aufgebrachten pastöse Kontaktierungsspur gebrannt. Sie wird dabei endgültig ausgehärtet und bildet nun einen elektrisch leitfähigen Bereich aus.

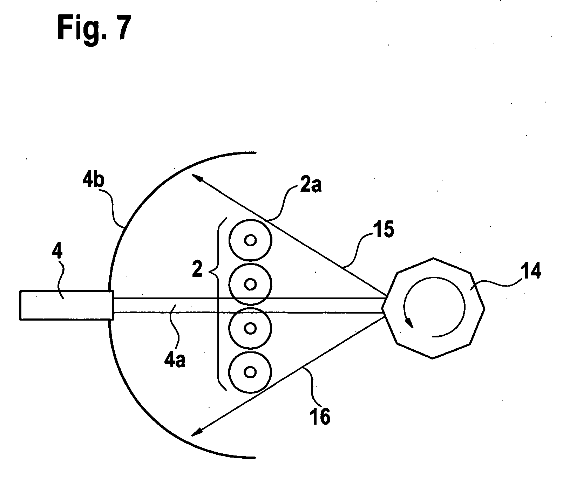

Sofern die Tintenstrahl-Düsenanordnung mehrere Tintenstrahldüsen **2a** umfasst, empfiehlt es sich, den Energieeintrag über die gesamten Einzeldüsen hinweg aufzufächern. Fig. 7 zeigt ein diesbezügliches Beispiel. Die Vorrichtung umfasst eine aus vier Tintenstrahldüsen **2a** bestehende Tintenstrahl-Düsehanordnung **2**, die entlang einer Linie angeordnet sind. Die Laservorrichtung **4** ist von einer hier kreisbogenförmig ausgebildeten Abschirmung **4b** umgeben. Der Laserstrahl **4a** wird auf einen rotierenden Spiegelkörper **14** gerichtet, der bei dem hier gezeigten Beispiel aus einem Prisma aus acht Mantelflächen besteht. Der Laserstrahl wird in der Reflexion an dem Spiegelkörper in zwei Teilstrahlen **15** und **16** aufgespreizt. Diese schließen die Tintenstrahldüsen **2a** vollständig in einem dabei gebildeten Öffnungswinkel ein. Bei der Rotation des Spiegelkörpers wird die durch die Teilstrahlen **15** und **16** aufgespannte Fläche vollständig durch das Laserlicht überstrichen. Damit werden die aus den Tintenstrahldüsen ausgestoßenen Droplets innerhalb der Fläche erfasst und mit dem flächenhaft aufgefächerten Laserstrahl beaufschlagt. Die Rotation des Spiegelkörpers erfolgt dabei entweder hinreichend schnell, sodass der abgelenkte Laserstrahl praktisch jedes aus den Düsen ausgestoßene Droplet erfasst, oder die Rotation des Spiegelkörpers ist über eine Synchronisationseinheit mit der Ansteuerung der Tintenstrahldüsen so abgestimmt, dass der abgelenkte Laserstrahl sich immer genau zu dem Zeitpunkt im Bereich einer Tintenstrahldüse befindet, wenn diese ein Droplet ausstößt.

Anstelle des rotierenden Spiegelkörpers können auch andere Auffächerungseinrichtungen zur Anwendung kommen, die zeitgleich die Umgebung jeder einzelnen Tintenstrahldüse mit einem eigenen Teilstrahl des Lasers beaufschlagt oder die gesamte Tintenstrahl-Düsenanordnung überstreicht. So können insbesondere Anordnungen aus einem Strahlteiler mit mehreren von dem Strahlteiler abzweigenden und in Richtung der Tintenstrahldüsen geführte Lichtleiter verwendet werden.

Möglich ist auch die Verwendung eines optischen Prismas oder eines Diffusors für ein Zerstreuen des einfallenden Laserstrahls oder die Verwendung eines Beugungsgitters, wobei die durch das Gitter erzeugten Intensitätsmaxima auf die Umgebungen der Tintenstrahldüsen einjustiert sind.

Das erfindungsgemäße Verfahren und die erfindungsgemäße Vorrichtung wurden anhand von Ausführungsbeispielen erläutert. Im Rahmen fachmännischen Handelns sind weitere Ausführungformen möglich. Diese ergeben sich insbesondere aus den Unteransprüchen.

## Patentansprüche

1. Verfahren zum Kontaktieren eines Halbleitersubstrates mittels eines Strahldruckverfahrens,
mit den Verfahrensschritten
- Bereitstellen eines Kontaktiermittels (1) in einem niedrigviskosen Ausgangszustand,
- Hindurchtreiben des niedrigviskosen Kontaktiermittels durch eine Düsenanordnung (2),
- Beaufschlagen des Kontaktiermittels mit einem Energieeintrag und/oder einem chemischen Reaktionsmittel (4, 10, 12, 13) zum Überführen des Kontaktiermittels in einen höherviskosen Endzustand (5) unmittelbar nach dem Düsendurchtritt
**dadurch gekennzeichnet, dass**
das Beaufschlagen des Kontaktiermittels durch einen in die Flugbahn des Kontaktiermittels gerichteten Laserstrahl (4, 4a) und/oder durch eine gerichtete Ultraviolett- oder Infrarotstrahlung, ein gerichtetes Wärmefeld, eine gerichtete Mikrowellenstrahlung (10), einen chemisch aktiven Gasstrahl (12) und/oder eine Plasmaeinwirkung (13) erfolgt.

2. Verfahren nach Anspruch 1,
**dadurch gekennzeichnet, dass**
das Beaufschlagen des Kontaktiermittels durch eine strahlförmig auf Kontaktmitteldroplets (3) gerichtete Einwirkung erfolgt.

3. Verfahren nach einem der vorhergehenden Ansprüche,
**dadurch gekennzeichnet, dass**
das Beaufschlagen des Kontaktiermittels zeitlich pulsförmig erfolgt, wobei eine Zeittaktung der pulsförmigen Beaufschlagung mit einer Zeittaktung eines Pulsbetriebs der Düsenanordnung (2) synchronisiert ist.

4. Verfahren nach einem der vorhergehenden Ansprüche,
**dadurch gekennzeichnet, dass**
das Beaufschlagen des Kontaktiermittels durch eine aufgefächerte Strahleinwirkung mit einem Überstreichen eines Druckbereichs mindestens einer Düse, insbesondere Tintenstrahldüse (2a) erfolgt.

5. Verfahren nach einem der vorhergehenden Ansprüche,
**dadurch gekennzeichnet, dass**
das Beaufschlagen selektiv auf eine Einwirkung auf einzelne stoffliche Anteile des Kontaktiermittels (1) abgestimmt ist, wobei über eine dadurch bewirkte Änderung des Mischungsverhältnisses des Kontaktiermittels eine gezielte Viskositätsänderung bewirkt wird.

6. Vorrichtung zum Kontaktieren eines Halbleitersubstrates mittels eines Strahldruckverfahrens,
**gekennzeichnet durch**
eine eine Tintenstrahl-Düsenanordnung (2) mindestens abschnittsweise umschließende Plasmazuführung (13) oder eine Gaszuführung zum Abgeben eines herangeführten Plasmas oder eines reaktiven Gases in Richtung von aus der Tintenstrahl-Düsenanordnung ausgestoßenen Droplets (3) zum Auftreffen auf die Droplets oder zum Ausbilden einer die Droplets umgebenden reaktiven Atmosphäre unmittelbar vor der Mündung der Tintenstrahl-Düsenanordnung.

7. Vorrichtung zum Kontaktieren eines Halbleitersubstrates mittels eines Strahldruckverfahrens; enthaltend
ein Vorratsbehältnis mit einem niedrigviskosen Kontaktiermittel (1), eine Düsenanordnung (2) **gekennzeichnet durch** eine auf einen Strahlbereich der Düsenanordnung gerichtete energetische und/oder chemische Beaufschlagungseinheit (4, 10, 12, 13).

8. Vorrichtung nach Anspruch 7,
**dadurch gekennzeichnet, dass**
die Beaufschlagungseinheit (4, 10, 12, 13) eine Auffächerungsanordnung (14) für ein mindestens zweidimensionales Verteilen der Beaufschlagung über einen Druckbereich von mindestens zwei Düsen, insbesondere Tintenstrahldüsen (2a) aufweist.

9. Vorrichtung nach Anspruch 7 oder 8,
**dadurch gekennzeichnet, dass**
die Beaufschlagungseinheit als eine Laservorrichtung (4) ausgebildet ist.

10. Vorrichtung nach einem der Ansprüche 7 bis 9,
**dadurch gekennzeichnet, dass**
die Beaufschlagungseinheit als eine gerichtete thermische Strahleinheit, eine Mikrowellenstrahleinheit (10), eine Gasstrahleinheit (12) für ein chemisch aktives Gas und/oder eine Plasmaeinheit (13) ausgebildet ist.

## Claims

1. Method for contacting a semiconductor substrate by a jet printing method, comprising the method steps of
- providing a contact medium (1) in a low-viscosity initial state,
- propelling the low-viscosity contact medium through a nozzle arrangement (2),
- applying an energy input and/or a chemical reactant (4, 10, 12, 13) to the contact medium to bring the contact medium into a higher-viscosity final state (5) immediately downstream from the passage through the nozzle,
**characterised in that** the application to the contact medium is provided by a laser beam (4, 4a) directed into the travel path of the contact medium and/or by a directed ultraviolet or infrared radiation, a directed heat field, a directed microwave radiation (10), a chemically active gas jet (12) and/or a plasma effect (13).

2. Method according to claim 1, **characterised in that** the application to the contact medium is provided by an effect directed onto contact medium droplets (3) in the form of a beam.

3. Method according to either of the preceding claims, **characterised in that** the application to the contact medium is provided in timed pulses, the timing of the pulsed action being synchronised with the timing of a pulsed operation of the nozzle arrangement (2).

4. Method according to any of the preceding claims, **characterised in that** the application to the contact medium is provided by a fanned-out beam effect comprising coating a printing region of at least one nozzle, in particular inkjet nozzle (2a).

5. Method according to any of the preceding claims, **characterised in that** the application is selectively calibrated for an effect on individual material components of the contact medium (1), a targeted change in viscosity being brought about by the resulting change in the mixing ratio of the contact medium.

6. Device for contacting a semiconductor substrate by a jet printing method, **characterised by** a plasma supply (13) which encloses an inkjet nozzle arrangement (2) at least in portions or a gas supply for emitting an introduced plasma or a reactive gas towards droplets (3) ejected from the inkjet nozzle arrangement so as to strike the droplets or form a reactive atmosphere which surrounds the droplets directly upstream from the opening of the inkjet nozzle arrangement.

7. Device for contacting a semiconductor substrate by an inkjet method, containing a reservoir container comprising a low-viscosity contact medium (1) and a nozzle arrangement (2), **characterised by** an energy and/or chemical application unit (4, 10, 12, 13) directed onto a jet region of the nozzle arrangement.

8. Device according to claim 7, **characterised in that** the application unit (4, 10, 12, 13) comprises a fanning arrangement (14) for distributing the application at least in two dimensions over a printing region of at least two nozzles, in particular inkjet nozzles (2a).

9. Device according to either claim 7 or claim 8, **characterised in that** the application unit is in the form of a laser device (4).

10. Device according to any of claims 7 to 9, **characterised in that** the application unit is in the form of a directed thermal jet unit, a microwave beam unit (10), a gas jet unit (12) for a chemically active gas and/or a plasma unit (13).

## Revendications

1. Procédé pour établir un contact avec un substrat semi-conducteur au moyen d'un procédé d'impression par jet comprenant les étapes de procédé suivantes consistant à :
- préparer un agent de mise en contact (1) présentant un état initial de faible viscosité,
- entraîner l'agent de mise en contact de faible viscosité à travers un ensemble buse (2),
- solliciter l'agent de mise en contact par l'action d'une énergie et/ou d'un agent réactif chimique (4, 10, 12, 13) pour le faire passer dans un état final (5) de plus forte viscosité directement après le passage à travers la buse,
**caractérisé en ce que** la sollicitation de l'agent de mise en contact est réalisée par un faisceau laser (4, 4a) orienté dans la trajectoire de l'agent de mise en contact et/ou par un rayonnement ultraviolet ou infrarouge orienté, un champ de chauffage orienté, un rayonnement hyperfréquence (10) orienté, un jet de gaz (12) chimiquement actif et/ou un effet plasma (13).

2. Procédé selon la revendication 1, **caractérisé en ce que** la sollicitation de l'agent de mise en contact est réalisée par une action orientée sous forme de jet vers des gouttelettes d'agent de mise en contact (3).

3. Procédé selon l'une des revendications précédentes, **caractérisé en ce que** la sollicitation de l'agent de mise en contact est réalisée dans le temps sous forme pulsée, le cadencement temporel de l'application sous forme pulsée étant synchronisé avec un cadencement temporel d'un fonctionnement par impulsions de l'ensemble buse (2).

4. Procédé selon l'une des revendications précédentes, **caractérisé en ce que** la sollicitation de l'agent de mise en contact est réalisée par un effet de jet ventilé en balayant une zone d'impression d'au moins une buse, en particulier une buse à jet d'encre (2a).

5. Procédé selon l'une des revendications précédentes, **caractérisé en ce que** la sollicitation est ajustée de manière sélective à une action sur des portions matérielles individuelles de l'agent de mise en contact (1), une modification de viscosité ciblée étant provoquée par l'intermédiaire d'une modification ainsi provoquée du rapport de mélange de l'agent de mise en contact.

6. Dispositif pour établir un contact avec un substrat semi-conducteur au moyen d'un procédé d'impression par jet **caractérisé par** une amenée de plasma (13) entourant au moins par sections un ensemble buse à jet d'encre (2) ou une amenée de gaz pour faire passer un plasma acheminé ou un gaz réactif dans la direction de gouttelettes (3) éjectées hors de l'ensemble buse à jet d'encre pour venir heurter les gouttelettes ou pour réaliser une atmosphère réactive entourant les gouttelettes directement avant l'embouchure de l'ensemble buse à jet d'encre.

7. Dispositif pour établir un contact avec un substrat semi-conducteur au moyen d'un procédé d'impression par jet, contenant un réceptacle de stockage contenant un agent de mise en contact (1) de faible viscosité, un ensemble buse (2), **caractérisé par** une unité de sollicitation (4, 10, 12, 13) énergique et/ou chimique dirigée vers une zone de jet de l'ensemble buse à jet.

8. Dispositif selon la revendication 7, **caractérisé en ce que** l'unité de sollicitation (4, 10, 12, 13) présente un ensemble de ventilation (14) pour une répartition au moins bidimensionnelle de la sollicitation sur une zone d'impression d'au moins deux buses, en particulier des buses à jet d'encre (2a).

9. Dispositif selon la revendication 7 ou 8, **caractérisé en ce que** l'unité de sollicitation est réalisée sous forme de dispositif laser (4).

10. Procédé selon l'une des revendications 7 à 9, **caractérisé en ce que** l'unité de sollicitation est réalisée sous forme d'unité de jet thermique orientée, d'unité de rayonnements hyperfréquences (10), d'unité de jet de gaz (12) pour un gaz chimiquement actif et/ou d'unité de plasma (13).
